# FASCICULE DE BREVET EUROPEEN

(11) **EP 2 646 604 B1**
(45) Date de publication et mention de la délivrance du brevet: **06.01.2016**
(21) Numéro de dépôt: 11796938.6
(22) Date de dépôt: 29.11.2011
(51) Int. Cl.: C30B 11/00, C30B 29/06, H01L 23/367, F28F 3/04, F28F 13/00

(54) **ECHANGEUR THERMIQUE D'UN SYSTEME DE SOLIDIFICATION ET/OU DE CRISTALLISATION D'UN MATERIAU SEMI-CONDUCTEUR**
WÄRMETAUSCHER FÜR EIN SYSTEM ZUR VERFESTIGUNG UND/ODER KRISTALLISIERUNG EINES HALBLEITERS
HEAT EXCHANGER FOR A SYSTEM FOR SOLIDIFYING AND/OR CRYSTALLIZING A SEMICONDUCTOR

(30) Priorité: 29.11.2010 FR 1059867
(43) Date de publication de la demande: 09.10.2013
(73) Titulaire: Commissariat à l'Énergie Atomique et aux Énergies Alternatives, 75015 Paris (FR)
(72) Inventeur: PIHAN, Etienne, F-73290 La Motte Servolex (FR); CAMEL, Denis, F-73000 Chambery (FR); COUDURIER, Nicolas, F-73100 Brison-Saint-Innocent (FR)
(74) Mandataire: Novaimo
(86) Numéro de dépôt international: PCT/EP2011/071290
(87) Numéro de publication internationale: WO 2012/072633

(56) Documents cités:
- EP-A1- 0 169 270
- EP-A1- 2 014 803
- DE-A1- 3 323 896
- DE-A1-102005 014 051
- DE-A1-102008 029 951
- GB-A- 2 279 585
- US-A- 6 138 748
- US-A1- 2006 021 747
- US-A1- 2007 030 656
- US-B1- 6 604 575

## Description

La présente invention concerne le domaine technique de la solidification directionnelle de semi-conducteurs dans un creuset ou un moule avec une extraction de chaleur par le fond du creuset ou moule. De préférence, elle concerne des matériaux ayant une chaleur latente supérieure à 10⁹ J/m³ et/ou une conductivité thermique inférieure à 50 W/m.°C dans sa phase solide et/ou un couple matériau/creuset ayant une résistance thermique supérieure à 0.01 °C.m²/W. Elle concerne en particulier un échangeur permettant de refroidir un matériau contenu dans un creuset ou un moule, notamment un matériau semi-conducteur pour une application photovoltaïque. Elle concerne également un procédé de solidification et/ou de cristallisation d'un matériau semi-conducteur utilisant un tel échangeur.

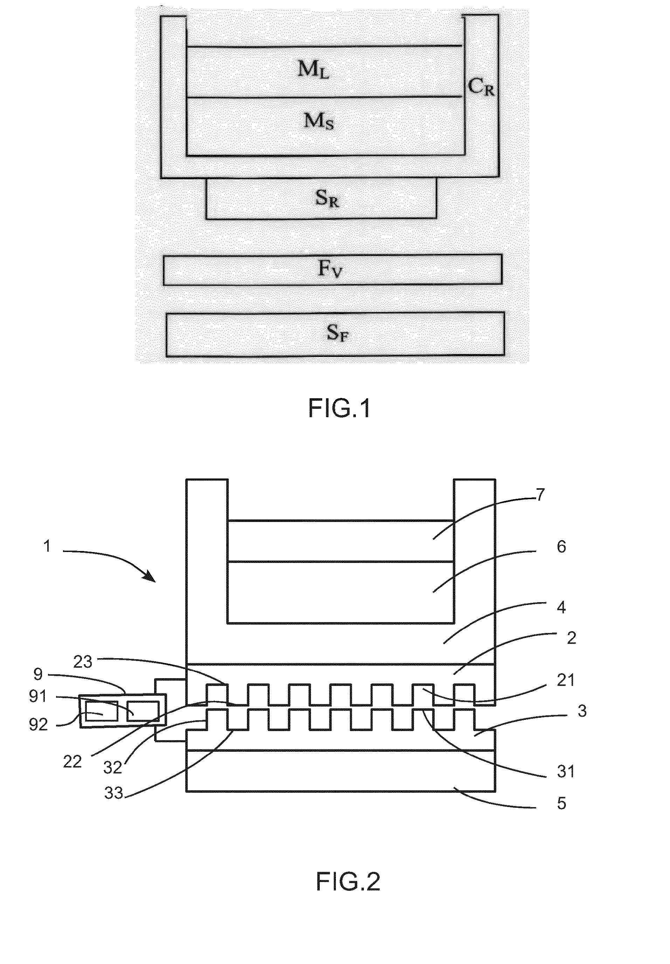

Dans les procédés de solidification dirigée en creuset de matériau à haut point de fusion (>1000°C), par exemple dans les procédés d'élaboration des lingots multi-cristallins de silicium photovoltaïque, la solidification dirigée est générée par un refroidissement contrôlé du fond du creuset. Comme représenté à la figure 1, le flux de chaleur est, dans l'état actuel de la technique, extrait par rayonnement d'un ensemble placé sous le creuset (souvent un ensemble supportant le creuset). Plus précisément, le matériau en phases liquide M_{L} et solide M_{S}, soit partiellement solidifié de manière directionnelle, est contenu dans le creuset Cr présentant une ouverture en haut. Le creuset est placé sur un ensemble chaud S_{R} lui servant éventuellement de support mécanique. L'ensemble chaud transmet le flux de chaleur extrait du matériau vers un ensemble froid S_{F} via un dispositif permettant de contrôler l'échange thermique entre les deux ensembles chaud et froid. Le contrôle de l'échange thermique se fait par exemple par rayonnement via un élément Fᵥ déterminant le rayonnement (par un facteur de vue). Complémentairement, le contrôle de l'échange thermique peut aussi être fait par exemple par conduction thermique entre les ensembles chaud et froid.

Le flux extrait est limité en valeur haute par le principe d'échange thermique, par les aires des surfaces de l'ensemble chaud S_{R} et de l'ensemble froid S_{F}, par le facteur de vue entre l'ensemble chaud S_{R} et l'ensemble froid S_{F}, par les propriétés des matériaux utilisés (conductivité thermique, émissivité) et par les températures des ensembles, lesquelles températures ne sont pas indépendantes des flux extraits. Le flux extrait au niveau du matériau (phases liquide et solide M_{L} et M_{S}) est de toute façon inférieur au flux extrait par l'ensemble sous le creuset.

Le flux extrait est limité en valeur basse soit par une isolation dont les moyens de mise en oeuvre sont dépendants du principe physique utilisé pour l'extraction (écran pour le rayonnement, mise hors contact pour la conduction), soit par un apport de chaleur par chauffage de l'ensemble chaud. Dans ce dernier cas, le flux est toujours extrait de l'ensemble chaud mais il est possible d'annuler ou de fortement minimiser le flux entre le creuset C_{R} et l'ensemble chaud et donc d'annuler ou de fortement minimiser le flux sortant du matériau. Toute la finesse de mise en application des extractions de chaleur consiste à avoir :
- la limite basse la plus basse possible,
- la limite haute la plus haute possible, et
- des plages de régulation les plus continues possibles entre ces deux limites et ceci par un moyen réalisable et pilotable de manière prévisible et reproductible, dans l'idéal sans consommables additionnels.

Autrement dit, on recherche une extraction de chaleur (ou flux thermique sortant du matériau) modulable en faisant varier le flux dans une gamme réalisable, ceci impliquant éventuellement l'utilisation de creusets ou de matériaux particuliers pour atteindre les limites de la gamme.

Tous les systèmes industriels ou de laboratoire connus et utilisés dans le domaine de la solidification dirigée du silicium pour des applications photovoltaïques ont en commun de permettre une régulation du flux de chaleur extrait au travers d'un dispositif disposé sous le creuset, soit :
- par rayonnement principalement :
   dans ce cas, la régulation se fait par :
      o un mouvement d'un écran (par exemple sur un dispositif DSS450HP commercialisé par la société GT Solar International, Inc.) définissant un facteur de vue entre une surface rayonnante de l'ensemble chaud et une surface de l'ensemble froid,
      o un mouvement d'une surface rayonnante de l'ensemble chaud (par exemple sur un dispositif Heat Exchanger Method commercialisé par la société Crystal Systems, Inc.) par rapport à une surface de l'ensemble froid, le rayonnement se faisant par exemple au travers d'un écran,
      o un contrôle de la température de l'ensemble chaud sous le creuset par chauffage (par exemple sur un dispositif SCU400 plus ou SCU800 plus commercialisé par la société ALD Vaccum Technologies GmgH) pour un système d'extraction figé en condition d'extraction en limite haute, c'est-à-dire une extraction non modulable régulée par un flux de chaleur fourni sous le creuset pour extraire moins de chaleur du matériau.
- par conduction principalement :
   dans ce cas, la régulation se fait par :
      o un contrôle de la température de l'ensemble froid sous le creuset, par injection d'un fluide relativement plus froid dans celui-ci (par exemple sur un dispositif Helium Cooled Heat Exchanger Method commercialisé par la société Crystal Systems, Inc.)
      o un mouvement mettant en contact via une résistance thermique contrôlable l'ensemble chaud et l'ensemble froid.

Dans le premier type de dispositif, la variation du flux est obtenue par variation de la surface d'échange par rayonnement et le flux maximal est limité par la surface maximale d'échange qui est au mieux voisine de la superficie de la section horizontale de l'ensemble chaud.

Dans le deuxième type de dispositif, la variation du flux échangé par conduction / convection est obtenue dans un cas par variation du débit d'un fluide, et, dans l'autre cas, par variation de l'épaisseur de gaz séparant deux plaques conductrices. Le flux maximal est alors limité soit par le débit maximal, la conductivité et la capacité calorifique du fluide, soit par la résistance thermique entre les deux plaques mises en contact, celle-ci résultant des inévitables défauts de planéité des deux surfaces en regard.

Les systèmes existants ne permettent pas d'avoir un flux maximum suffisant à basse température tout en assurant une bonne isolation à haute température. Le problème est de réussir à maintenir une extraction de chaleur élevée sous le creuset lorsque la hauteur de matériau à solidifier est élevée ou lorsque le creuset est un bon isolant thermique. Autrement dit, le problème consiste à augmenter le flux de chaleur qui peut être extrait du matériau à solidifier alors que la température du matériau est relativement basse. Par exemple, dans le cas de lingots de silicium multicristallin d'une hauteur de 20 à 45 cm avec un creuset en silice de 20 mm, le flux extrait par une surface simple rayonnante dans la gamme 800-1000°C est limité. Ceci limite le gradient thermique et la vitesse de solidification.

On peut imaginer solutionner le problème en augmentant la surface rayonnante du support de creuset par une simple augmentation des dimensions de celui-ci :
- On peut augmenter la surface rayonnante des faces latérales du support de creuset à condition que la surface froide soit adaptée. Ceci présente le défaut de localiser l'extraction de chaleur sur les cotés et d'induire un défaut d'homogénéité. Cette technique présente aussi le défaut d'ajouter une résistance thermique par conduction due à l'épaisseur ainsi augmentée du support de creuset.
- On peut augmenter la largeur et ainsi la surface rayonnante dans le fond du support de creuset. Cependant, le bloc échangeur ne peut être beaucoup plus large que le creuset et donc que le lingot sous peine de pénaliser l'homogénéité de l'extraction de chaleur. Le facteur d'augmentation de flux via la surface augmentée reste donc limité dans cette option.

Dans les systèmes existants, la répartition du flux sur la face inférieure du creuset est imposée par la méthode choisie pour augmenter le flux, et est donc directement liée à la valeur de flux choisie. Pourtant ce paramètre joue un rôle spécifique dans chacune des étapes du procédé (germination, cristallisation, refroidissement du solide), de sorte qu'il serait avantageux de pouvoir modifier cette répartition au fil des étapes du procédé.

Le but de l'invention est de fournir un échangeur permettant de remédier aux problèmes évoqués précédemment et améliorant les échangeurs connus de l'art antérieur. En particulier, l'invention propose un échangeur permettant une modulation et/ou un contrôle simple et précis du flux thermique extrait d'un creuset ou d'un moule, notamment pour une application de solidification et/ou de cristallisation d'un matériau semi-conducteur utilisé dans le domaine de l'énergie photovoltaïque. En outre, l'invention propose un procédé de solidification et/ou de cristallisation utilisant un tel échangeur.

Selon l'invention, l'échangeur thermique, notamment échangeur thermique d'un système de solidification et/ou de cristallisation d'un matériau semi-conducteur, comprend une première pièce et une deuxième pièce, les première et deuxième pièces étant déplaçables l'une par rapport à l'autre. La première pièce comprend des premiers reliefs et la deuxième pièce comprend des deuxièmes reliefs, les premiers reliefs étant destinés à coopérer avec les deuxièmes reliefs.

L'échangeur peut comprendre un élément de déplacement de la première pièce relativement à la deuxième pièce permettant de contrôler ou de réguler un flux de chaleur échangé, notamment un flux de chaleur échangé entre la première pièce et la deuxième pièce.

L'élément de déplacement peut comprendre un régulateur pour moduler la distance entre la première pièce et la deuxième pièce en fonction du flux de chaleur échangé souhaité, c'est-à-dire en fonction du flux de chaleur que l'on cherche à faire transiter dans l'échangeur, soit à extraire d'un moule ou creuset de solidification et/ou de cristallisation.

Le régulateur permet de positionner les première et deuxième pièces à au moins deux distances distinctes pour obtenir au moins deux flux de chaleur échangés distincts ou au moins deux coefficient d'échange de l'échangeur distincts ou deux coefficients d'échange distincts.

Le régulateur permet de faire varier continûment la distance entre les deux pièces entre une première position où une surface d'échange est minimale et une deuxième position où la surface d'échange est maximale.

Les premiers reliefs peuvent comprendre des creux et des saillies et les deuxièmes reliefs peuvent comprendre des creux et des saillies.

Le pas des saillies et des creux peut être variable le long d'une dimension de la première pièce et de la deuxième pièce.

La hauteur des saillies peut être variable le long d'une dimension d'au moins une des première et deuxième pièces.

Les premiers et deuxièmes reliefs peuvent coopérer par emboîtement de saillies dans des creux.

Les premiers reliefs peuvent présenter des saillies munies de flancs inclinés parallèles à des flancs inclinés de creux des deuxièmes reliefs.

Les premiers et deuxièmes reliefs peuvent avoir des structures parallélépipédiques, notamment des structures disposées selon un même axe longitudinal.

Les saillies des premiers reliefs peuvent être recouverts d'un premier matériau ayant des caractéristiques thermiques différentes du matériau constituant le reste de la première pièce, notamment ayant des caractéristiques isolantes thermiques.

Les saillies des deuxièmes reliefs peuvent être recouverts d'un deuxième matériau ayant des caractéristiques thermiques différentes du matériau constituant le reste de la deuxième pièce, notamment ayant des caractéristiques isolantes thermiques.

Les matériaux des première et deuxième pièces peuvent avoir des caractéristiques thermiques différentes.

La première pièce peut être destinée à être thermiquement liée à un creuset ou à un moule et la deuxième pièce peut être destinée à être thermiquement liée à une source froide.

L'échangeur peut comprendre un premier élément pour ménager une épaisseur de gaz modulable entre le creuset et la première pièce et/ou peut comprendre un deuxième élément pour ménager une épaisseur de gaz modulable entre la source froide et la deuxième pièce.

Au moins l'une des saillies de la première et/ou de la deuxième pièces peut être dimensionnée de sorte à venir en contact au fond des creux de la deuxième et/ou de la première pièces dans une position relative particulière des première et deuxième pièces.

Selon l'invention, un système de solidification et/ou de cristallisation d'un matériau semi-conducteur comprend un échangeur défini précédemment.

Selon l'invention, un procédé de solidification et/ou de cristallisation d'un matériau semi-conducteur utilise un échangeur défini précédemment et comprend :
- une étape de positionnement de la première pièce relativement à la deuxième pièce, et
- une étape de transfert thermique du creuset à la source froide, via les première et deuxième pièces de l'échangeur.

L'étape de positionnement peut être réalisée pendant l'étape de transfert thermique.

On peut faire varier le coefficient d'échange de l'échangeur entre le début et la fin de la solidification et/ou cristallisation. Pour ce faire, on peut faire varier la position relative des deux pièces pendant la solidification et/ou la cristallisation.

Les dessins annexés représentent, à titre d'exemples, différents modes d'exécution d'un échangeur selon l'invention.
La figure 1 est un schéma d'un échangeur connu de l'art antérieur.
La figure 2 est un schéma d'un premier mode de réalisation d'un échangeur selon l'invention.
La figure 3 est un schéma de détail du premier mode de réalisation d'un échangeur selon l'invention, l'échangeur étant représenté dans deux configurations.
La figure 4 est un graphique illustrant les évolutions de la température sous un creuset en fonction de la hauteur des saillies des première et deuxième pièces.
La figure 5 est un graphique illustrant les évolutions de la température sous un creuset en fonction du rapport de l'aire des surfaces des sections droites des saillies de la deuxième pièce sur l'aire des surfaces des sections droites des saillies de la première pièce, pour quatre valeurs de flux thermiques données.
La figure 6 est un schéma d'un deuxième mode de réalisation d'un échangeur selon l'invention.
La figure 7 est un graphique illustrant les évolutions du flux thermique transféré via un échangeur selon l'invention en fonction des positions relatives des première et deuxième pièces, pour sept valeurs de température de creuset données.
La figure 8 est un graphique illustrant les évolutions du flux thermique maximal transféré via un échangeur selon l'invention et via un échangeur connu de l'art antérieur en fonction d'une température de creuset.
La figure 9 est un graphique illustrant les évolutions du flux thermique minimal transféré via un échangeur selon l'invention et via un échangeur connu de l'art antérieur en fonction d'une température de creuset.
La figure 10 est un graphique illustrant les évolutions de l'amplitude du coefficient d'échange permise par un échangeur selon l'invention en fonction d'une température de creuset.
La figure 11 est un schéma d'un troisième mode de réalisation d'un échangeur selon l'invention.
La figure 12 est un schéma d'un cinquième mode de réalisation d'un échangeur selon l'invention.
La figure 13 est un schéma d'un sixième mode de réalisation d'un échangeur selon l'invention.
La figure 14 est un schéma d'un septième mode de réalisation d'un échangeur selon l'invention.
La figure 15 est un schéma d'un huitième mode de réalisation d'un échangeur selon l'invention.
La figure 16 est un schéma d'un neuvième mode de réalisation d'un échangeur selon l'invention.
La figure 17 est un schéma d'un dixième mode de réalisation d'un échangeur selon l'invention.
La figure 18 est un schéma d'un douzième mode de réalisation d'un échangeur selon l'invention.
La figure 19 est un schéma d'un treizième mode de réalisation d'un échangeur selon l'invention.

Un premier mode de réalisation d'échangeur thermique 1 représenté à la figure 2 est décrit ci-après. Il équipe par exemple un système de solidification et/ou de cristallisation d'un matériau semi-conducteur, notamment d'un matériau semi-conducteur photovoltaïque. Le système de solidification et/ou de cristallisation fait par exemple partie d'un four.

Le système de solidification et/ou de cristallisation comprend un creuset 4 (ou moule) destiné à contenir le matériau 6, 7 à solidifier et/ou à cristalliser, une source froide 5 destinée à refroidir le creuset et un échangeur 1 destiné à réguler le flux thermique transféré du creuset à la source froide. Le matériau peut présenter une phase liquide 7 et une phase solide 6.

L'échangeur comprend une première pièce 2 et une deuxième pièce 3. L'échangeur comprend également un moyen ou élément de déplacement de la première pièce relativement à la deuxième pièce. La première pièce comprend des premiers reliefs 21 et la deuxième pièce comprend des deuxièmes reliefs 31. Les premiers reliefs sont destinés à coopérer avec les deuxièmes reliefs. De préférence, les premiers et deuxièmes reliefs coopèrent par emboîtement. Par exemple, les premiers et deuxièmes reliefs peuvent être complémentaires.

Dans une première position relative des première et deuxième pièces, l'échangeur présente un premier coefficient d'échange et dans une deuxième position relative des première et deuxième pièces, l'échangeur présente un deuxième coefficient d'échange, différent du premier coefficient d'échange. En effet, entre les deux positions relatives, les aires des surfaces des première et deuxième pièces en regard sont différentes, il s'ensuit que le coefficient d'échange est différent. En particulier, les aires des surfaces des première et deuxième pièces en regard sont différentes parce que les aires des surfaces latérales des saillies en regard sont différentes.

L'élément 9 de déplacement permet de déplacer, notamment en translation les première et deuxième pièces l'une par rapport à l'autre. Cet élément comprend un actionneur 91.

L'échangeur selon l'invention permet de contrôler le flux de chaleur extrait du creuset ou du moule.

Comme vu précédemment, l'élément de déplacement de la première pièce relativement à la deuxième pièce permet de contrôler ou de réguler le flux de chaleur échangé, notamment un flux de chaleur échangé entre la première pièce et la deuxième pièce, en particulier en régulant le coefficient de transfert thermique de l'échangeur.

De préférence, l'élément de déplacement comprend un régulateur 92 permettant de moduler la distance entre la première pièce et la deuxième pièce en fonction du flux de chaleur échangé souhaité, c'est-à-dire en fonction du flux de chaleur que l'on cherche à faire transiter dans l'échangeur, soit à extraire d'un moule ou creuset de solidification et/ou de cristallisation. De préférence, le régulateur commande ou pilote l'actionneur qui positionne les première et deuxième pièces l'une par rapport à l'autre. En fonction d'un flux de chaleur échangé souhaité au niveau de l'échangeur ou en fonction d'un coefficient d'échange souhaité, le régulateur détermine une commande et délivre cette commande à l'actionneur. En exécutant cette commande, l'actionneur positionne les première et deuxième pièces de façon adéquate pour atteindre le flux de chaleur échangé souhaité au niveau de l'échangeur ou le coefficient d'échange souhaité.

Le régulateur peut comprendre des éléments de régulation permettant de mettre en oeuvre une régulation en boucle ouverte ou une régulation en boucle fermée.

Le régulateur permet de faire varier continûment la distance entre les deux pièces entre une première position où une surface d'échange est minimale et une deuxième position où la surface d'échange est maximale.

L'échangeur permet d'élargir la gamme de valeur haute de flux thermique, qu'il est possible d'extraire du matériau via le creuset ou le moule, au-delà des limites des systèmes actuels. En élargissant cette gamme, il est possible d'augmenter les rendements matière et la productivité via la hauteur de lingots solidifiés et/ou les vitesses de solidification. Il est également possible d'augmenter certains critères de qualité en choisissant, à vitesse et hauteur de cristallisation identique, d'augmenter le gradient thermique dans le matériau et ainsi de contrôler le rapport vitesse de cristallisation/gradient thermique à l'interface solide-liquide sur une gamme plus étendue.

En particulier, l'échangeur thermique selon l'invention permet d'extraire la chaleur d'un matériau à solidifier, en particulier d'extraire la chaleur du matériau lors de sa cristallisation en lingot à haute température. L'échangeur thermique permet :
- de faire varier le coefficient d'échange de l'échangeur entre le début et la fin de cristallisation (par exemple pour le silicium entre 1400°C et 600°C pour la température de la première pièce). A haute température, le rayonnement génère naturellement des flux de chaleur élevés : l'échangeur est alors mis dans une position telle que le coefficient d'échange est faible (par exemple inférieur à 30 W.m⁻².°C⁻¹) en éloignant les première et deuxième pièces. A l'inverse, à basse température, le rayonnement génère des flux très faibles. L'échangeur est mis dans une position telle que le coefficient d'échange est important (par exemple supérieur à 60 W.m⁻².°C⁻¹) en rapprochant les première et deuxième pièces. Ainsi, le flux thermique extrait peut être maintenu le plus constant possible.
- de choisir la répartition spatiale du coefficient d'échange de l'échangeur.

Pour ce faire :
- l'échangeur comprend une première pièce (pièce chaude) en liaison thermique avec le creuset ou le moule et une deuxième pièce (pièce froide) en liaison thermique avec une source froide comme une boîte à eau,
- des empreintes ou reliefs complémentaires, notamment de formes complexes, sont réalisées dans les faces en regard des première et deuxième pièces. La géométrie de ces empreintes peut être caractérisée par leurs surfaces développées et/ou leur distribution spatiale et/ou leur profondeur,
- un mouvement relatif des première et deuxième pièces permet de faire varier continûment la surface d'échange entre les deux pièces, entre une position isolante où la surface d'échange est minimale (pièces écartées) et une position conductrice où cette surface est maximale (pièces emboîtées l'une dans l'autre),
- de façon optionnelle, chacune des première et deuxième pièces est composée de deux types de matériaux permettant de répondre aux fonctions isolantes et conductrices. Cette hybridation permet de renforcer toutes les propriétés de l'échangeur énumérées auparavant,
- de façon optionnelle, la deuxième pièce peut être séparée de la source froide de façon à renforcer la fonction d'isolation ou la première pièce peut être séparée du creuset de façon à renforcer la fonction d'isolation.

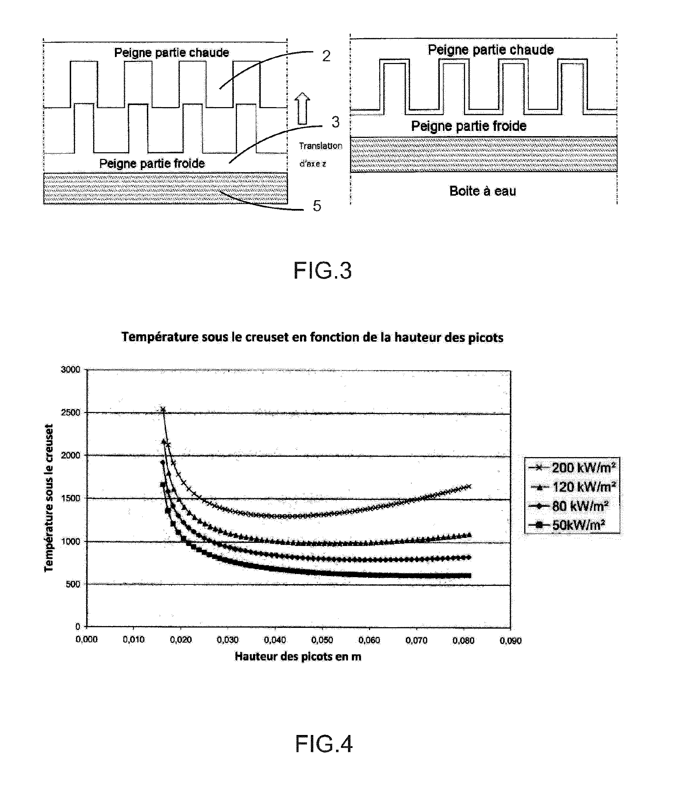

La réalisation d'empreintes ou reliefs complémentaires dans deux faces en regard des première et deuxième pièces et le déplacement relatif des première et deuxième pièces permettent, comme illustré à la figure 3, de réaliser une surface d'échange ayant une aire significativement supérieure à l'aire d'une section droite horizontale de l'une des première et deuxième pièces. Le rapport entre ces aires peut par exemple être de 1 à 10.

Ce concept permet de faire varier le flux échangé par rayonnement jusqu'à des valeurs nettement plus grandes que dans les dispositifs connus. De plus, il permet d'ajouter une contribution d'échange par conduction / convection dans le gaz se trouvant entre les première et deuxième pièces. Cette contribution est réglable par le choix des jeux entre les faces en regard des première et deuxième pièces. La gamme de flux accessible peut être ajustée par le choix de la géométrie, le flux maximum extrait par rayonnement dépendant de la surface maximale d'échange et la contribution de l'échange par conduction dépendant en plus de l'épaisseur des jeux entre les surfaces en regard des première et deuxième pièces et de la conductivité thermique du gaz entre les première et deuxième pièces. Cette gamme peut aussi être ajustée par le choix de la nature des matériaux des première et deuxième pièces en regard, de façon à adapter leur conductivité thermique et leur émissivité, ainsi que celui de la nature du gaz remplissant l'espace entre ces surfaces. Les pièces peuvent également être constituées d'une combinaison de matériaux différents. Il est ainsi réalisé, par un simple déplacement relatif des deux pièces en regard, une augmentation contrôlée, jusqu'à un facteur pouvant dépasser 10, du flux extrait à température donnée de la première pièce. Le flux maximum peut donc être supérieur jusqu'à un facteur 10 à celui extrait dans les conditions habituelles d'échange par rayonnement entre des pièces présentant des faces planes. Ce facteur peut encore être fortement augmenté en se plaçant dans des conditions (jeu et nature du gaz) pour lesquelles la contribution de l'échange par conduction/convection à travers le film de gaz restant entre les première et deuxième pièces devient importante.

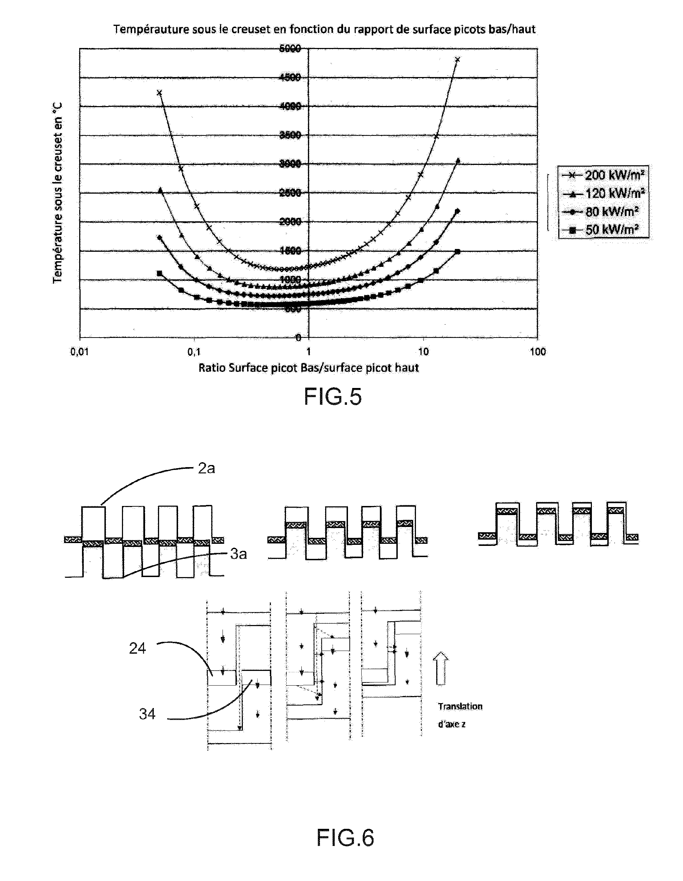

Pour atteindre les flux maxima visés, la géométrie de l'empreinte ou relief doit de préférence répondre à des critères précis :
- si les saillies (par exemple des picots) sont trop longues, la résistance thermique est augmentée étant donné la longueur du matériau, et si les saillies sont trop courtes, on augmente peu l'aire de la surface d'échange par rapport à l'aire de la surface S0 d'échange entre deux pièces planes. Comme représenté sur la figure 4, l'optimum de hauteur des saillies varie en fonction du flux thermique désiré. Plus ce flux est grand, plus la hauteur optimale des saillies est faible, car les pertes de valeur dues à la résistance thermique des saillies augmentent d'autant plus.
- une autre limite de cette architecture est constituée par le ratio de l'aire de la surface horizontale des saillies conductrices de la première pièce par rapport à l'aire de la surface horizontale des saillies conductrices de la deuxième pièce. Chaque configuration (en fonction de la hauteur des saillies, du flux souhaité...) présente son optimum. Cependant, une plus grande surface de saillie sur la première pièce est préférable pour permettre d'avoir une température la plus haute possible, par rapport à la température des saillies de la deuxième pièce, afin d'avoir un échange par radiation facilité, comme illustré à la figure 5.

Selon les flux minima visés en position isolante, il peut être utile de séparer la deuxième pièce de la source froide pour créer une résistance thermique entre ces deux éléments : la valeur du minimum peut être ainsi diminuée (par exemple pour obtenir un coefficient inférieur à 30 W.m⁻².°C⁻¹).

Comme représenté à la figure 6, dans un deuxième mode de réalisation, l'échangeur est tel qu'il comprend des première 2a et deuxième 3a pièces ayant des saillies en matériau conducteur et dont les extrémités sont revêtues d'un matériau isolant 24, 34. Ainsi, dans la position où les isolants de la première pièce et de la deuxième pièce sont en regard (représentée par le schéma supérieur gauche de la figure 6), les première et deuxième pièces sont séparées par une couche continue ou sensiblement continue de matériau isolant.

Les faces conductrices latérales des saillies sont mises en regard par mouvement relatif des première et deuxième pièces, comme représenté par le schéma supérieur du milieu de la figure 6, et, dans une plus large mesure, comme représenté par le schéma supérieur de droite de la figure 6.

La mise en oeuvre d'un tel échangeur composite à haute température présente des difficultés technologiques.

En effet, les dilatations thermiques et les jeux mécaniques peuvent poser problème lors du déplacement des première et deuxième pièces l'une par rapport à l'autre, notamment en translation. De plus, des contacts entre les saillies pourraient avoir lieu, ce qui pourrait engendrer de violents phénomènes de transferts locaux pouvant endommager l'échangeur. Enfin, il n'est pas évident de disposer un matériau isolant sur les saillies.

En outre, l'échangeur selon l'invention peut permettre de faire varier selon les besoins la répartition spatiale du flux thermique extrait, soit transféré du creuset 4 ou moule à la source froide 5. Cela peut être obtenu par la réalisation de reliefs non uniformes le long des surfaces des première et deuxième pièces, c'est-à-dire en faisant varier les largeur et hauteur des saillies. Ceci offre la possibilité de réaliser une large variété de répartitions spatiales du flux thermique et, de plus, de faire varier cette répartition en fonction du déplacement relatif des première et deuxième pièces, comme cela est illustré dans les modes de réalisation suivants.

Les résultats expérimentaux suivants ont été obtenus avec un échangeur ayant une forme de révolution, comportant 7 saillies d'une hauteur de 65mm (15mm de matériau isolant au dessus de 50mm de matériau conducteur). L'épaisseur des saillies est de 9mm et l'épaisseur de gaz entre les picots est de 1.5mm. Le gaz contenu dans le four est de l'argon. La source froide 5 est une boîte à eau en cuivre de 160 mm de diamètre. Elle utilise de l'eau à une température de 28°C pour le refroidissement. Le creuset 4 est en quartz de diamètre 160mm et contenait l'équivalent de 5kg de silicium. Des thermocouples sont situés sous une plaque, notamment en graphite, d'une épaisseur de 3mm située sous le creuset.

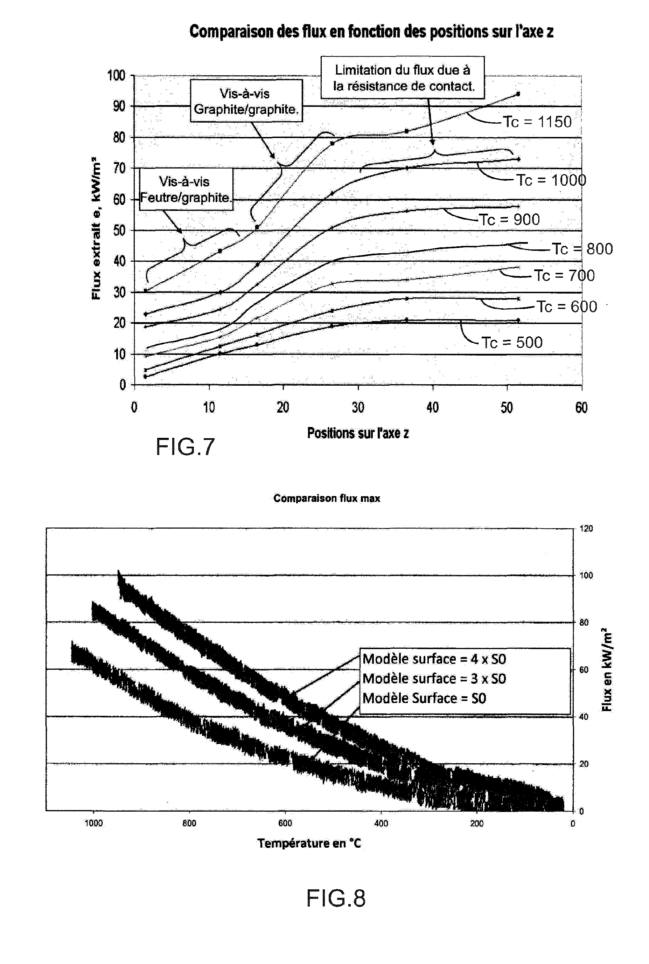

La figure 7 représente le flux extrait en fonction de la position de la source froide et donc de la position relative des première et deuxième pièces. Plus la position de la boîte à eau est haute, plus les première et deuxième pièces sont imbriquées et plus la surface d'échange en vis-à-vis est grande.

On observe trois comportements sur ce graphique :
- z<15mm : Une première partie où le matériau isolant aux extrémités des saillies sont en vis-à-vis avec le matériau conducteur des saillies. Le flux thermique augmente proportionnellement au déplacement.
- 15mm< z < 32 mm : Une deuxième partie où le matériau conducteur des différentes saillies rentre en vis-à-vis. L'augmentation du flux en fonction du déplacement des la première pièce relativement à la deuxième pièce est alors plus grande.
- z>32mm : Une dernière partie où le flux thermique stagne par rapport au déplacement. Ceci peut être expliqué par les différentes résistances de contact présentes aux interfaces (source froide/deuxième pièce, première pièce/plaque creuset) qui limitent le flux total qui peut être extrait du creuset à la source froide. Ces résistances de contact sont si grandes que même si l'on diminue significativement la résistance thermique entre les première et deuxième pièces, la résistance thermique totale du système stagne. Ainsi, pour maîtriser le flux thermique (en cas de contact entre deux saillies dû à une déformation par exemple), les résistances de contacts sont une très bonne alternative.

La figure 8 représente l'évolution du flux thermique maximum pour différentes surfaces d'échange comparé au flux thermique maximum qui peut être extrait par un système présentant des surfaces planes en vis-à-vis, l'aire de la surface en vis-à-vis d'un tel système étant notée S0.

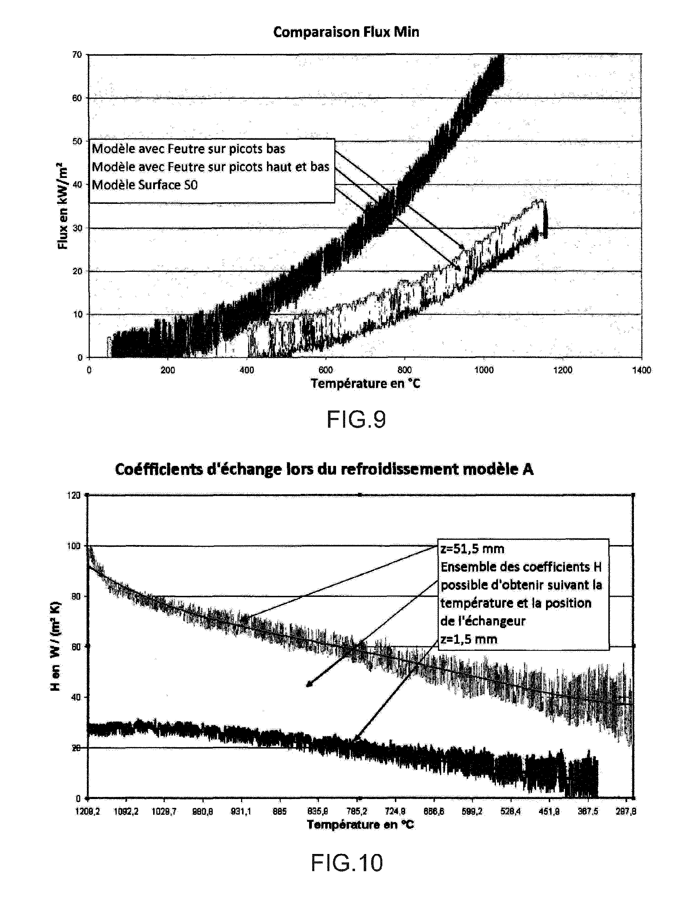

Les flux thermiques minimum obtenus pour ces mêmes modèles sont comparés sur la figure 9. Le modèle ayant une aire de surface d'échange de 4xS0 a le flux maximal le plus élevé. Il ne possède qu'une seule couche de matériau sur les saillies. Son isolation est légèrement moins bonne que celle du modèle dont l'aire de la surface d'échange est de 3xS0. Ce modèle possède une couche de matériau isolant sur chacune des saillies. L'aire de la surface d'échange en vis-à-vis pour ces deux modèles quand le système est placé en position isolante est environ deux fois moins grande que S0, d'où une grande résistance thermique. Enfin, le flux thermique minimal du modèle à surface S0 est le même que son flux thermique maximal, cet échangeur ne présentant pas de surface d'échange modulable.

La figure 10 représente toute l'étendue des coefficients d'échange H et donc l'étendue des flux thermiques qu'il est possible d'obtenir avec un échangeur selon l'invention.

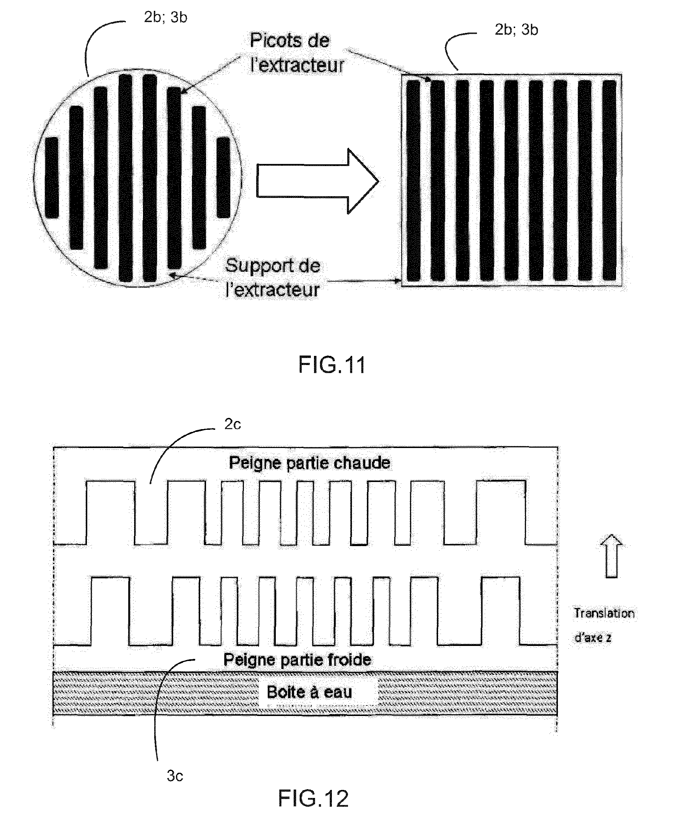

Dans un troisième mode de réalisation représenté à la figure 11, les première 2b et deuxième 3b pièces peuvent avoir des sections horizontales circulaires ou carrées. Alternativement, l'une des première et deuxième pièces peut avoir une section circulaire, tandis que l'autre des première et deuxième pièces peut avoir une section carrée.

Dans un quatrième mode de réalisation (non représenté), la géométrie des reliefs est adaptée pour obtenir une augmentation désirée de l'aire de la surface d'échange dans un espace donné. Pour ce faire, on peut, pour augmenter les aires des surfaces d'échange, minimiser les dimensions latérales des reliefs et augmenter leur hauteur. Les reliefs peuvent notamment comprendre un réseau de picots, de barreaux, de tubes, de cônes, de plaques à dépouilles ou de tubes à dépouilles. Pour une hauteur disponible faible, il est intéressant de diminuer la dimension latérale des reliefs et/ou de passer de configurations rectangulaires à des configurations circulaires.

Une géométrie très efficace comprend un réseau de picots cylindriques coopérant avec des trous circulaires. De façon à conserver par ailleurs la conductance la meilleure possible, dans chacune des deux pièces, il est souhaitable que l'aire de la section des picots soit environ la moitié de l'aire de la section totale de la première pièce ou de la deuxième pièce S. Le facteur maximal d'augmentation de la surface d'échange Sₜₒₜ/S est alors 1+2H/D où D est le diamètre des picots et H leur hauteur.

Pour une géométrie de relief comprenant des nervures coopérant avec des rainures, notamment des nervures parallèles coopérant avec des rainures parallèles, ce facteur est 1+H/d où d est la largeur des nervures et H leur hauteur.

Dans un cinquième mode de réalisation représenté à la figure 12, la géométrie des reliefs est telle qu'elle permet d'obtenir une répartition non-uniforme du flux thermique entre les première 2c et deuxième 3c pièces. En effet, les saillies au centre des première et deuxième pièces sont plus fines qu'à leur périphérie. Ainsi, la densité de saillies est plus importante au centre des pièces et il est possible de transférer un flux thermique de la première pièce à la deuxième pièce plus important au centre des pièces qu'à leur périphérie. De préférence, la hauteur des saillies est uniforme sur l'ensemble des pièces ou sur chacune des pièces.

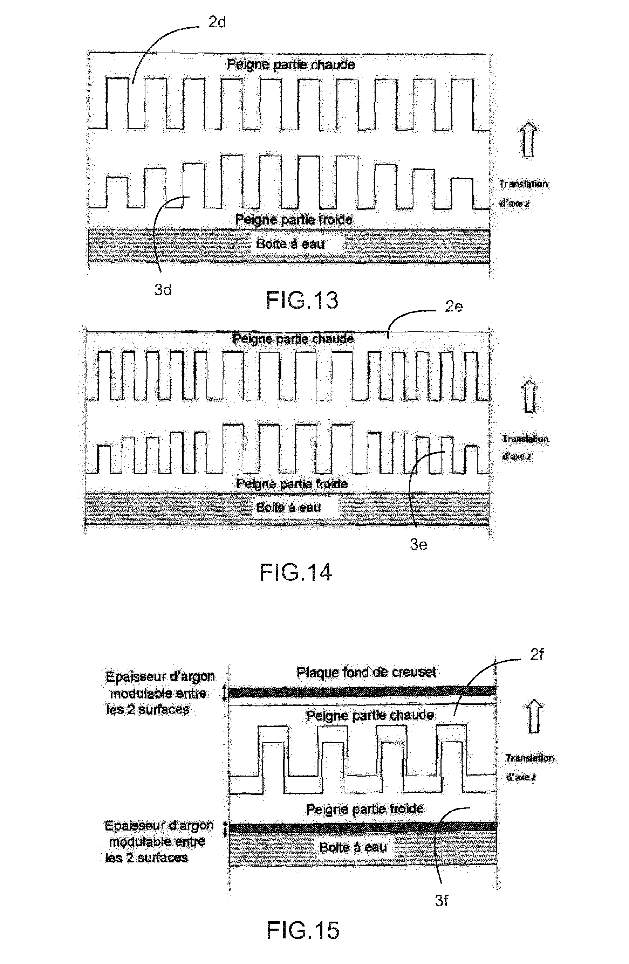

Dans un sixième mode de réalisation représenté à la figure 13, la géométrie des reliefs est aussi telle qu'elle permet d'obtenir une répartition non-uniforme du flux thermique entre les première 2d et deuxième 3d pièces. En effet, les saillies au centre de la deuxième pièce sont plus hautes qu'à leur périphérie. Alternativement, les saillies au centre de la première pièce sont plus hautes qu'à leur périphérie. Ainsi, il est possible de transférer un flux thermique de la première pièce à la deuxième pièce plus important au centre des pièces qu'à leur périphérie.

De préférence, dans un septième mode de réalisation représenté à la figure 14, les cinquième et sixième modes de réalisation peuvent être combinés. Dans ce mode de réalisation, les saillies sont plus hautes au centre de la deuxième pièce 3e et sont plus denses à la périphérie des première 2e et deuxième 3e pièces. Ainsi, en cours de solidification, un plus grand flux thermique peut être extrait du creuset au milieu des première et deuxième pièces dans une première position relative de ces pièces et un flux thermique homogène peut être extrait du creuset dans une deuxième position relative des pièces.

Dans un huitième mode de réalisation représenté à la figure 15, on ménage entre le fond du creuset et la première pièce 2f et/ou entre la source froide et la deuxième pièce 3f une épaisseur de gaz modulable, notamment une épaisseur d'argon modulable. Cette épaisseur ou ces épaisseurs permettent de limiter le flux thermique transféré du creuset à la source froide.

Dans un neuvième mode de réalisation, on maximise le flux thermique pouvant être transféré de la première pièce à la deuxième pièce en minimisant les jeux mécaniques entre les première et deuxième pièces.

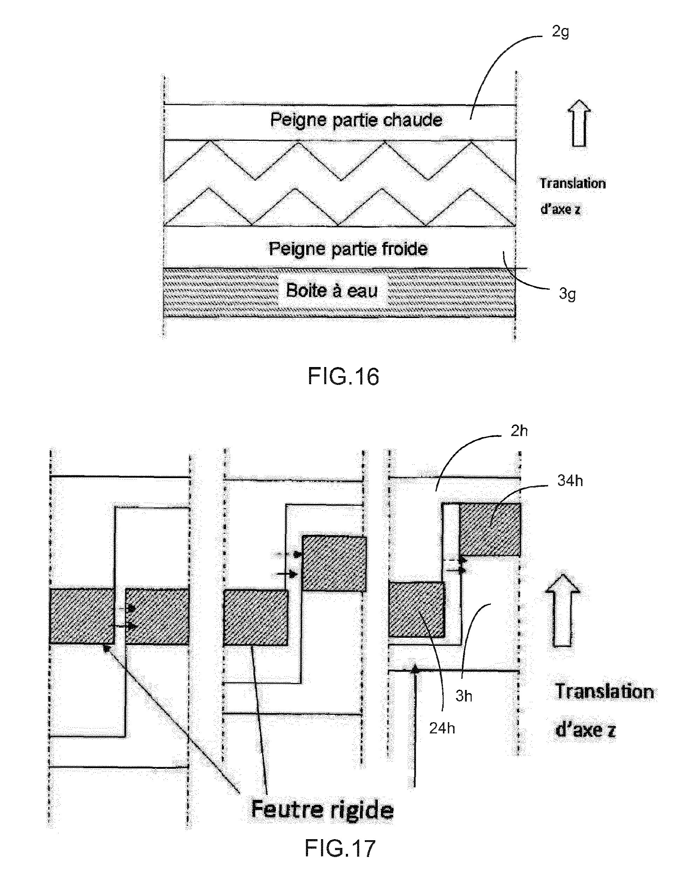

Dans une variante du neuvième mode de réalisation, représentée à la figure 16, on maximise le flux thermique entre les première 2g et deuxième 3g pièces en minimisant les jeux mécaniques tout en résolvant la difficulté des dilatations thermiques des matériaux. Pour ce faire, on opte par exemple pour des reliefs ayant des structures circulaires, notamment de révolution. Ceci permet d'avoir des jeux mécaniques faibles en périphérie des première et deuxième pièces tout en tolérant un jeu mécanique adapté aux dilatations thermiques à ces endroits.

Dans un dixième mode de réalisation représenté à la figure 17, on minimise le flux thermique minimum entre les première 2h et deuxième 3h pièces en augmentant, par rapport au deuxième mode de réalisation, l'épaisseur du matériau isolant 24h, 34h aux extrémités des saillies.

Dans un onzième mode de réalisation (non représenté), on minimise le flux thermique minimum en réalisant une chicane entre les éléments de matériau isolant se trouvant aux extrémités des saillies. Ainsi, le flux thermique qui pouvait être rayonné entre les saillies est bloqué. Ceci réduit les transferts par rayonnement direct en configuration isolante au niveau du jeu mécanique entre les première et deuxième pièces.

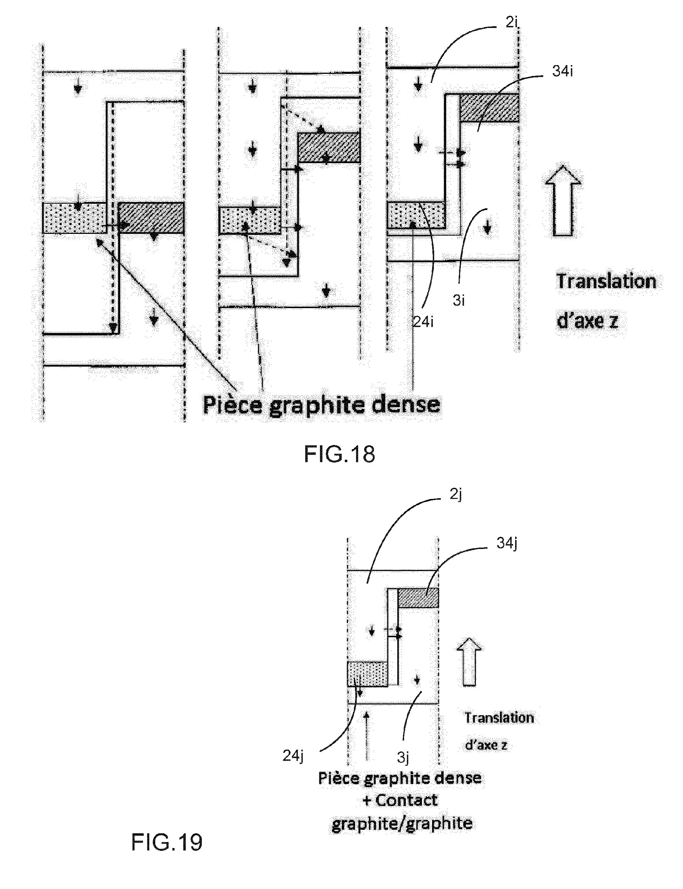

Dans un douzième mode de réalisation représenté à la figure 18, on maximise le flux thermique maximum en n'utilisant pas de matériau isolant au niveau des extrémités des saillies de l'une ou l'autre des première et deuxième pièces. On utilise, au niveau des saillies de l'une des première et deuxième pièces, un matériau conducteur 24i. On utilise, au niveau des saillies de l'autre des première et deuxième pièces, un matériau isolant 34i.

Dans un treizième mode de réalisation représenté à la figure 19, on maximise le flux thermique maximum en prévoyant au niveau des saillies des première et/ou deuxième pièces une possibilité de contact entre les extrémités des saillies et les fonds des creux entre saillies. Le contact peut être total ou partiel. Ceci permet d'ajouter une forte composante de conduction entre les première et deuxième pièces. Le contact peut se faire via des matériaux conducteurs 24j ou isolants 34j prévus aux extrémités des saillies.

Sauf incompatibilité technique ou logique, les différents modes de réalisation de l'échangeur décrits plus haut peuvent être combinés entre eux.

Dans les différents modes de réalisation, le matériau conducteur constituant principalement les première et deuxième pièces peut comprendre ou peut être du graphite, notamment du graphite dense.

De même, dans les différents modes de réalisation, le matériau isolant disposé aux extrémités des saillies peut comprendre ou peut être du feutre.

Dans les différents modes de réalisation de l'échangeur selon l'invention, l'échangeur comprend un élément de déplacement de la première pièce relativement à la deuxième pièce.

L'invention concerne aussi un procédé de solidification et/ou de cristallisation d'un matériau semi-conducteur utilisant un échangeur tel que décrit précédemment. Le procédé est caractérisé en ce qu'il comprend :
- une étape de positionnement de la première pièce relativement à la deuxième pièce, et
- une étape de transfert thermique du creuset à la source froide, via les première et deuxième pièces de l'échangeur.

Par exemple, l'étape de positionnement peut être réalisée pendant l'étape de transfert thermique. Ainsi, il est possible de modifier le flux thermique transféré du creuset à la source froide en cours de solidification et/ou de cristallisation. Ainsi, on peut modifier le coefficient d'échange de l'échangeur entre le début et la fin de la solidification et/ou cristallisation. Pour ce faire, on peut faire varier la position relative des deux pièces pendant la solidification et/ou la cristallisation.

## Revendications

1. Echangeur thermique (1) d'un système de solidification et/ou de cristallisation d'un matériau semi-conducteur, comprenant une première pièce (2 ; 2a ; 2b ; 2c ; 2d ; 2e ; 2f ; 2g ; 2h ; 2i ; 2j) et une deuxième pièce (3 ; 3a ; 3b ; 3c ; 3d ; 3e ; 3f ; 3g ; 3h ; 3i ; 3j), les première et deuxième pièces étant déplaçables l'une par rapport à l'autre, **caractérisé en ce que** la première pièce comprend des premiers reliefs (21) et la deuxième pièce comprend des deuxièmes reliefs (31), les premiers reliefs étant destinés à coopérer avec les deuxièmes reliefs et **en ce qu'**il comprend un élément de déplacement (9) de la première pièce relativement à la deuxième pièce permettant de contrôler un flux de chaleur échangé, **en ce que** l'élément de déplacement comprend un régulateur (92) pour moduler la distance entre la première pièce et la deuxième pièce en fonction du flux de chaleur échangé souhaité et **en ce que** :
- les premiers reliefs comprennent des creux (23) et des saillies (22) et les deuxièmes reliefs comprennent des creux (33) et des saillies (32), en particulier le pas des saillies et des creux étant variable le long d'une dimension de la première pièce et de la deuxième pièce, ou
- la hauteur des saillies est variable le long d'une dimension d'au moins une des première et deuxième pièces et/ou les premiers et deuxièmes reliefs coopèrent par emboîtement de saillies dans des creux.

2. Echangeur selon la revendication 1, **caractérisé en ce que** le régulateur permet de positionner les première et deuxième pièces à au moins deux distances distinctes pour obtenir au moins deux flux de chaleur échangés distincts ou deux coefficients d'échange distincts.

3. Echangeur selon la revendication 1 ou 2, **caractérisé en ce que** le régulateur permet de faire varier continûment la distance entre les deux pièces entre une première position où une surface d'échange est minimale et une deuxième position où la surface d'échange est maximale.

4. Echangeur selon l'une des revendications précédentes, **caractérisé en ce que** les premiers reliefs présentent des saillies munies de flancs inclinés parallèles à des flancs inclinés de creux des deuxièmes reliefs.

5. Echangeur selon l'une des revendications précédentes, **caractérisé en ce que** les premiers et deuxièmes reliefs ont des structures parallélépipédiques, notamment des structures disposées selon un même axe longitudinal.

6. Echangeur selon l'une des revendications précédentes, **caractérisé en ce que** les saillies des premiers reliefs sont recouverts d'un premier matériau (24 ; 24h ; 24i ; 24j) ayant des caractéristiques thermiques différentes du matériau constituant le reste de la première pièce, notamment ayant des caractéristiques isolantes thermiques, et/ou **en ce que** les saillies des deuxièmes reliefs sont recouverts d'un deuxième matériau (34 ; 34h ; 34i ; 34j) ayant des caractéristiques thermiques différentes du matériau constituant le reste de la deuxième pièce, notamment ayant des caractéristiques isolantes thermiques.

7. Echangeur selon l'une des revendications précédentes, **caractérisé en ce que** les matériaux des première et deuxième pièces ont des caractéristiques thermiques différentes.

8. Echangeur selon l'une des revendications précédentes, **caractérisé en ce que** la première pièce est destinée à être thermiquement liée à un creuset (4) ou à un moule et **en ce que** la deuxième pièce est destinée à être thermiquement liée à une source froide (5).

9. Echangeur selon l'une des revendications précédentes, **caractérisé en ce qu'**il comprend un premier élément pour ménager une épaisseur de gaz modulable entre le creuset et la première pièce et/ou **en ce qu'**il comprend un deuxième élément pour ménager une épaisseur de gaz modulable entre la source froide et la deuxième pièce.

10. Echangeur selon l'une des revendications précédentes, **caractérisé en ce qu'**au moins une des saillies de la première et/ou de la deuxième pièces est dimensionnée de sorte à venir en contact au fond des creux de la deuxième et/ou de la première pièces dans une position relative particulière des première et deuxième pièces.

11. Système de solidification et/ou de cristallisation d'un matériau semi-conducteur comprenant un échangeur selon l'une des revendications précédentes.

12. Procédé de solidification et/ou de cristallisation d'un matériau semi-conducteur utilisant un échangeur selon l'une des revendications 1 à 10, **caractérisé en ce qu'**il comprend :
- une étape de positionnement de la première pièce relativement à la deuxième pièce, notamment l'étape de positionnement étant réalisée pendant l'étape de transfert thermique et
- une étape de transfert thermique du creuset à la source froide, via les première et deuxième pièces de l'échangeur.

13. Procédé selon la revendication 12, **caractérisé en ce qu'**on fait varier le coefficient d'échange de l'échangeur entre le début et la fin de la solidification et/ou cristallisation.

## Patentansprüche

1. Wärmetauscher (1) für ein System zur Verfestigung und/oder Kristallisierung eines Halbleiters, umfassend ein erstes Teil (2; 2a; 2b; 2c; 2d; 2e; 2f; 2g; 2h; 2i; 2j) und ein zweites Teil (3; 3a; 3b; 3c; 3d; 3e; 3f; 3g; 3h; 3i; 3j), wobei das erste und das zweite Teil relativ zueinander verschiebbar sind, **dadurch gekennzeichnet, dass** das erste Teil erste Reliefs (21) aufweist und das zweite Teil zweite Reliefs (31) aufweist, wobei die ersten Reliefs dazu bestimmt sind, mit den zweiten Reliefs zusammenzuwirken, und dass er ein Element zum Verschieben (9) des ersten Teils relativ zu dem zweiten Teil zum Steuern eines ausgetauschten Wärmestroms aufweist, dass das Element zum Verschieben einen Regler (92) aufweist, um den Abstand zwischen dem ersten Teil und dem zweiten Teil je nach dem gewünschten ausgetauschten Wärmestrom zu modulieren und, dass:
- die ersten Reliefs Rücksprünge (23) und Vorsprünge (22) aufweisen und die zweiten Reliefs Rücksprünge (33) und Vorsprünge (32) aufweisen, wobei insbesondere der Abstand der Vorsprünge und der Rücksprünge entlang einer Abmessung des ersten Teils und des zweiten Teils variabel ist oder
- die Höhe der Vorsprünge entlang einer Abmessung von mindestens einem des ersten und zweiten Teils variabel ist und/oder die ersten und zweiten Reliefs durch Ineinandergreifen von Vorsprüngen in Rücksprünge zusammenwirken.

2. Wärmetauscher nach Anspruch 1, **dadurch gekennzeichnet, dass** der Regler ermöglicht, das erste und zweite Teil in mindestens zwei unterschiedlichen Abständen zu positionieren, um mindestens zwei unterschiedliche ausgetauschte Wärmeströme oder zwei unterschiedliche Austauschkoeffizienten zu erhalten.

3. Wärmetauscher nach Anspruch 1 oder 2, **dadurch gekennzeichnet, dass** der Regler ermöglicht, kontinuierlich den Abstand zwischen den zwei Teilen zwischen einer ersten Position, in der eine Austauschfläche minimal ist, und einer zweiten Position, in der die Austauschfläche maximal ist, zu variieren.

4. Wärmetauscher nach einem der vorhergehenden Ansprüche, **dadurch gekennzeichnet, dass** die ersten Reliefs Vorsprünge aufweisen, die mit geneigten Flanken ausgestattet sind, die parallel zu den geneigten Flanken von Rücksprüngen der zweiten Reliefs sind.

5. Wärmetauscher nach einem der vorhergehenden Ansprüche, **dadurch gekennzeichnet, dass** die ersten und zweiten Reliefs quaderförmige Strukturen aufweisen, insbesondere Strukturen, die nach einer gleichen Längsachse angeordnet sind.

6. Wärmetauscher nach einem der vorhergehenden Ansprüche, **dadurch gekennzeichnet, dass** die Vorsprünge der ersten Reliefs mit einem ersten Material (24; 24h; 24i; 24j) beschichtet sind, das andere thermische Eigenschaften aufweist, als das Material, das den Rest des ersten Teils bildet, das insbesondere thermisch isolierende Eigenschaften aufweist, und/oder dass die Vorsprünge der zweiten Reliefs mit einem zweiten Material (34; 34h; 34i; 34j) beschichtet sind, das andere thermische Eigenschaften aufweist, als das Material, das den Rest des zweiten Teils bildet, das insbesondere thermisch isolierende Eigenschaften aufweist.

7. Wärmetauscher nach einem der vorhergehenden Ansprüche, **dadurch gekennzeichnet, dass** die Materialien des ersten und zweiten Teils verschiedene thermische Eigenschaften aufweisen.

8. Wärmetauscher nach einem der vorhergehenden Ansprüche, **dadurch gekennzeichnet, dass** das erste Teil dazu bestimmt ist, thermisch mit einem Tiegel (4) oder mit einer Form verbunden zu werden, und dass das zweite Teil dazu bestimmt ist, thermisch mit einer Kältequelle (5) verbunden zu werden.

9. Wärmetauscher nach einem der vorhergehenden Ansprüche, **dadurch gekennzeichnet, dass** er ein erstes Element aufweist, um eine variierbare Dicke von Gas zwischen dem Tiegel und dem ersten Teil vorzusehen und/oder dass er ein zweites Element aufweist, um eine variierbare Dicke von Gas zwischen der Kältequelle und dem zweiten Teil vorzusehen.

10. Wärmetauscher nach einem der vorhergehenden Ansprüche, **dadurch gekennzeichnet, dass** mindestens einer der Vorsprünge des ersten und/oder des zweiten Teils dimensioniert ist, um mit dem Boden der Rücksprünge des zweiten und/oder des ersten Teils in einer besonderen, relativen Position des ersten und zweiten Teils in Kontakt zu kommen.

11. System zur Verfestigung und/oder Kristallisierung eines Halbleiters, umfassend einen Wärmetauscher nach einem der vorhergehenden Ansprüche.

12. Verfahren zur Verfestigung und/oder Kristallisierung eines Halbleiters, das einen Wärmetauscher nach einem der Ansprüche 1 bis 10 verwendet, **dadurch gekennzeichnet, dass** es Folgendes aufweist:
- einen Schritt des Positionierens des ersten Teils relativ zu dem zweiten Teil, wobei insbesondere der Schritt des Positionierens während des Schrittes der Wärmeübertragung durchgeführt wird, und
- einen Schritt der Wärmeübertragung vom Tiegel zu der Kältequelle über das erste und zweite Teil des Wärmetauschers.

13. Verfahren nach dem Anspruch 12, **dadurch gekennzeichnet, dass** der Austauschkoeffizient des Wärmetauschers zwischen dem Beginn und dem Ende der Verfestigung und/oder Kristallisierung variiert wird.

## Claims

1. Heat exchanger (1) for a solidification and/or crystallization system for a semiconductor material, comprising a first member (2; 2a; 2b; 2c; 2d; 2e; 2f; 2g; 2h; 2i; 2j) and a second member (3; 3a; 3b; 3c; 3d; 3e; 3f; 3g; 3h; 3i; 3j), the first and second members being movable with respect to each other, **characterized in that** the first member comprises a first pattern of relief (21) and the second member comprises a second pattern of relief (31), the first pattern of relief being designed to cooperate with the second pattern of relief and **in that** it comprises an element for displacement (9) of the first member relative to the second member allowing an exchanged heat flux to be controlled, **in that** the displacement element comprises a regulator (92) for modulating the distance between the first member and the second member according to the desired exchanged heat flux and **in that**:
- the first pattern of relief comprises recesses (23) and protrusions (22) and the second pattern of relief comprises recesses (33) and protrusions (32), in particular the pitch of the protrusions and of the recesses is variable along one dimension of the first member and of the second member; or
- the height of the protrusions is variable along one dimension of at least one of the first and second members; and/or the first and second patterns of relief cooperate by nesting of protrusions into recesses.

2. Exchanger according to Claim 1, **characterized in that** the regulator allows the first and second members to be positioned at at least two different distances so as to obtain at least two different exchanged heat fluxes or two different exchange coefficients.

3. Exchanger according to either of Claims 1 and 2, **characterized in that** the regulator allows the distance between the two members to be continuously varied between a first position where an exchange surface area is a minimum and a second position where the exchange surface area is a maximum.

4. Exchanger according to one of the preceding claims, **characterized in that** the first pattern of relief has protrusions with inclined sides parallel to inclined sides of recesses of the second pattern of relief.

5. Exchanger according to one of the preceding claims, **characterized in that** the first and second patterns of relief have parallelepipedic structures, notably structures disposed along the same longitudinal axis.

6. Exchanger according to one of the preceding claims, **characterized in that** the protrusions of the first pattern of relief are covered with a first material (24; 24h; 24i; 24j) exhibiting thermal characteristics that are different from the material composing the rest of the first member, notably having thermally insulating characteristics and/or **in that** the protrusions of the second pattern of relief are covered with a second material (34; 34h; 34i; 34j) exhibiting thermal characteristics that are different from the material composing the rest of the second member, notably exhibiting thermally insulating characteristics.

7. Exchanger according to one of the preceding claims, **characterized in that** the materials of the first and second members have different thermal characteristics.

8. Exchanger according to one of the preceding claims, **characterized in that** the first member is designed to be thermally linked to a crucible (4) or to a mould and **in that** the second member is designed to be thermally linked to a cold source (5).

9. Exchanger according to one of the preceding claims, **characterized in that** it comprises a first element for including a modulatable thickness of gas between the crucible and the first member and/or **in that** it comprises a second element for including a modulatable thickness of gas between the cold source and the second member.

10. Exchanger according to one of the preceding claims, **characterized in that** at least one protrusion of the first and/or of the second members is dimensioned so as to come into contact in the bottom of the recesses of the second and/or of the first members in a particular relative position of the first and second members.

11. System for solidification and/or for crystallization of a semiconductor material comprising an exchanger according to one of the preceding claims.

12. Process for solidification and/or for crystallization of a semiconductor material using an exchanger according to one of Claims 1 to 10, **characterized in that** it comprises:
- a step for positioning the first member relative to the second member, notably the positioning step being carried out during the heat transfer step, and
- a step for heat transfer from the crucible to the cold source, via the first and second members of the exchanger.

13. Method according to Claim 12, **characterized in that** the exchange coefficient of the exchanger is varied between the beginning and the end of the solidification and/or crystallization.
